# EUROPEAN PATENT APPLICATION

(11) **EP 4 528 944 A2**
(43) Date of publication of application: **26.03.2025**
(21) Application number: 24196826.2
(22) Date of filing: 27.08.2024
(51) Int. Cl.: H01S 5/06, G01J 1/00, H01S 5/0683

(54) **APPARATUS AND METHOD FOR LASER DIODE CALIBRATION**

(30) Priority: 20.09.2023 IN 202311063176
(71) Applicant: Honeywell International Inc., Charlotte, NC 28202 (US)
(72) Inventor: LENIN, Kaligaselvi, Charlotte, 28202 (US); TURK, Fethi, Charlotte, 28202 (US); THINGALKODI, Ilanchezhian, Charlotte, 28202 (US); H B, Akshay, Charlotte, 28202 (US); BROWN, Andy Walker, Charlotte, 28202 (US); SUBRAMANIAN, Hariprasath, Charlotte, 28202 (US)
(74) Representative: Haseltine Lake Kempner LLP

(57) **Abstract**

A laser illumination device is provided. For example, a laser illumination device comprises a laser diode having an anode and a cathode, a photodiode having an anode and a cathode connected to the cathode of the laser diode, a laser diode driver having a voltage output connected to the anode of the laser diode and a feedback input connected to the anode of the photodiode, and a variable resistor with a selectable resistance value connected between the anode of the photodiode and ground. The selectable resistance value is selected to maintain a reference voltage on the anode of the photodiode to reverse bias the photodiode.

## Description

### FIELD OF THE INVENTION

Embodiments of the present disclosure generally relate to imaging systems, and, more particularly, to imaging systems comprising laser diodes.

### BACKGROUND

In some types of imaging systems, laser illumination devices are used to generate laser light. Some of these laser illumination devices comprise a laser diode (often a Vertical Cavity Surface Emitting Laser or VCSEL) to generate the laser light and a photodiode to provide feedback. The laser diode and the photodiode are often integrated into a single package.

A laser driver (also termed a laser diode drive) provides constant current to operate the laser. The photodiode current is used as feedback to keep the optical power level of the laser the same by adjusting the current source output. This is called Constant Power Mode. The photodiode current is proportional to the optical power output of the laser diode. The optical power output of the laser diode changes (typically reduces) due to changes in the temperature of the laser diode body over time and resistive heating. When the optical power output of the laser diode changes, the laser driver detects the change in the photodiode current and adjusts the output of the laser drive to the laser diode to maintain the desired optical power output.

However, such laser illumination devices are plagued by technical challenges and limitations. Due to manufacturing variations and other factors, each laser diode / photodiode package is typically calibrated once before starting its usage. The laser diode / photodiode package may also be calibrated as needed during its operational life. The calibration process for conventional laser diode / photodiode packages is complex and time-consuming.

Through applied effort, ingenuity, and innovation, many of these identified problems have been solved by developing solutions that are included in embodiments of the present disclosure, many examples of which are described in detail herein.

### BRIEF SUMMARY

Various embodiments described herein relate to laser illumination devices and associated biasing a photodiode of laser illumination devices and methods of calibrating laser illumination devices.

In accordance with various embodiments of the present disclosure, a laser illumination device is provided. In some embodiments, a laser illumination device comprises a laser diode having an anode and a cathode, a photodiode having an anode and a cathode connected to the cathode of the laser diode, a laser diode driver having a voltage output connected to the anode of the laser diode and a feedback input connected to the anode of the photodiode, and a variable resistor with a selectable resistance value connected between the anode of the photodiode and ground. The selectable resistance value is selected to maintain a reference voltage on the anode of the photodiode to reverse bias the photodiode.

In some embodiments, the variable resistor with the selectable resistance value comprises a digital potentiometer.

In some embodiments, the laser illumination device further comprises a microcontroller in communication with the digital potentiometer for selecting the selectable resistance value.

In some embodiments, the laser illumination device further comprises first and second resistors connected in series between the cathodes of the laser diode and the photodiode and ground, and a current sense analog-to-digital controller (ADC) connected in parallel across one of the first and second resistors for measuring current through the one of the first and second resistors.

In some embodiments, the laser illumination device further comprises a fixed resistor connected in series with the variable resistor.

In some embodiments, the reference voltage is 1.24 volts and the fixed resistor has a resistance value of 6200 ohms.

In some embodiments, the variable resistor has a selectable resistance value of between 0 and 50,000 ohms.

In accordance with various embodiments of the present disclosure, a method of method of biasing a photodiode of a laser illumination device is provided. In some embodiments, the method comprises connecting a cathode of a laser diode to a cathode of a photodiode, connecting an output of a laser diode driver to an anode of the laser diode, connecting an anode of the photodiode to a feedback input of the laser diode driver, connecting a variable resistor with a selectable resistance value between the anode of the photodiode and ground, and selecting a resistance value of the variable resistor to maintain a reference voltage on the anode of the photodiode to reverse bias the photodiode.

In accordance with various embodiments of the present disclosure, a method of method of calibrating a laser illumination device is provided. In some embodiments, the method comprises connecting a cathode of a laser diode to a cathode of a photodiode, connecting an output of a laser diode driver to an anode of the laser diode, connecting an anode of the photodiode to a feedback input of the laser diode driver, connecting a variable resistor with a selectable resistance value between the anode of the photodiode and ground, for each of a plurality of different selected resistance values of the variable resistor, determining a photodiode current and a laser diode current, for each pair of adjacent values of the plurality of different selected resistance values of the variable resistor, calculating a ratio of (i) a difference between the photodiode current at a second selected resistance value and the photodiode current at a first selected resistance value and (ii) a difference between the laser diode current at the second selected resistance value and the laser diode current at the first selected resistance value, determining a maximum one of the calculated ratios, determining a target photodiode current by multiplying the maximum one of the calculated ratios by a photodiode reference current value within an operating range of the photodiode, and calculating an operating resistance value of the variable resistor using the target photodiode current.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a block diagram of an example device in which example embodiments of the present disclosure may be implemented;
FIG. 2 is a simplified circuit diagram of an example laser illumination device in accordance with example embodiments of the present disclosure; and
FIG. 3 is a flowchart illustrating an example method of calibrating a laser illumination device in accordance with example embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," "bottom," "left," "right," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The phrases "in one example," "according to one example," "in some examples," and the like generally mean that the particular feature, structure, or characteristic following the phrase may be included in at least one example of the present disclosure and may be included in more than one example of the present disclosure (importantly, such phrases do not necessarily refer to the same example).

If the specification states a component or feature "may," "can," "could," "should," "would," "preferably," "possibly," "typically," "optionally," "for example," "as an example," "in some examples," "often," or "might" (or other such language) be included or have a characteristic, that specific component or feature is not required to be included or to have the characteristic. Such component or feature may be optionally included in some examples, or it may be excluded.

The word "example" or "exemplary" is used herein to mean "serving as an example, instance, or illustration." Any implementation described herein as "example" or "exemplary" is not necessarily to be construed as preferred or advantageous over other implementations.

The term "electronically coupled," "electronically coupling," "electronically couple," "in communication with," "in electronic communication with," or "connected" in the present disclosure refers to two or more elements or components being connected through wired means and/or wireless means, such that signals, electrical voltage/current, data and/or information may be transmitted to and/or received from these elements or components.

The term "component" may refer to an article, a device, or an apparatus that may comprise one or more surfaces, portions, layers and/or elements. For example, an example component may comprise one or more substrates that may provide underlying layer(s) for the component and may comprise one or more elements that may form part of and/or are disposed on top of the substrate. In the present disclosure, the term "element" may refer to an article, a device, or an apparatus that may provide one or more functionalities.

Various embodiments of the present disclosure overcome the above technical challenges and difficulties and provide various technical improvements and advantages. For example, various embodiments of the present disclosure provide an example laser illumination device. Various embodiments of the present disclosure provide an example method of biasing a photodiode of a laser illumination device. Various embodiments of the present disclosure provide an example method of calibrating a laser illumination device.

Conventionally, a laser driver monitors photodiode current as feedback by forward biasing the photodiode. Usually, the response of a photodiode at its forward biased region is non-linear to the optical power. As such, calculation intensive methods like linear interpolation are conventionally used during calibration of the laser diode / photodiode package, resulting in a calibration algorithm that consumes a significant amount of time to calculate the required parameters.

In various embodiments of the present disclosure, the photodiode is reverse biased. When the photodiode is reverse biased, the response of photodiode current is linear with optical power output of the laser diode such that the voltage and current of the photodiode change linearly (directly proportional) in response to changes in the optical power output. In various embodiments, this linear response simplifies and therefore speeds the process for calibrating the laser diode / photodiode package.

In various embodiments, a laser illumination device (which may also be termed a laser light source or a laser source) comprises a laser diode having an anode and a cathode, a photodiode having an anode and a cathode connected to the cathode of the laser diode, a laser diode driver having a voltage output connected to the anode of the laser diode and a feedback input connected to the anode of the photodiode, and a variable resistor with a selectable resistance value connected between the anode of the photodiode and ground. In various embodiments, the selectable resistance value is selected to maintain a reference voltage on the anode of the photodiode to reverse bias the photodiode.

In various embodiments, a laser illumination device of embodiments of the present disclosure is used with any suitable imaging device or for any suitable imaging method. In various embodiments, a laser illumination device of embodiments of the present disclosure is used with a peritoneal dialysis device. Peritoneal dialysis removes waste and extra fluid through the blood vessels that line the walls of a patient's abdomen. Peritoneal dialysis involves inserting a catheter through the patient's abdominal wall and pumping a dialysis solution into the abdominal cavity. After a set amount of time, the solution is drained and discarded. Conventionally, some of the fluid removed from the patient's abdominal cavity is retained and sent for laboratory analysis to determine, for example, the presence of leukocytes (white blood cells), such as neutrophils, monocytes, and/or lymphocytes. In some peritoneal dialysis devices, some of the fluid removed from the patient's abdominal cavity is analyzed by an imaging device to detect the presence of leukocytes.

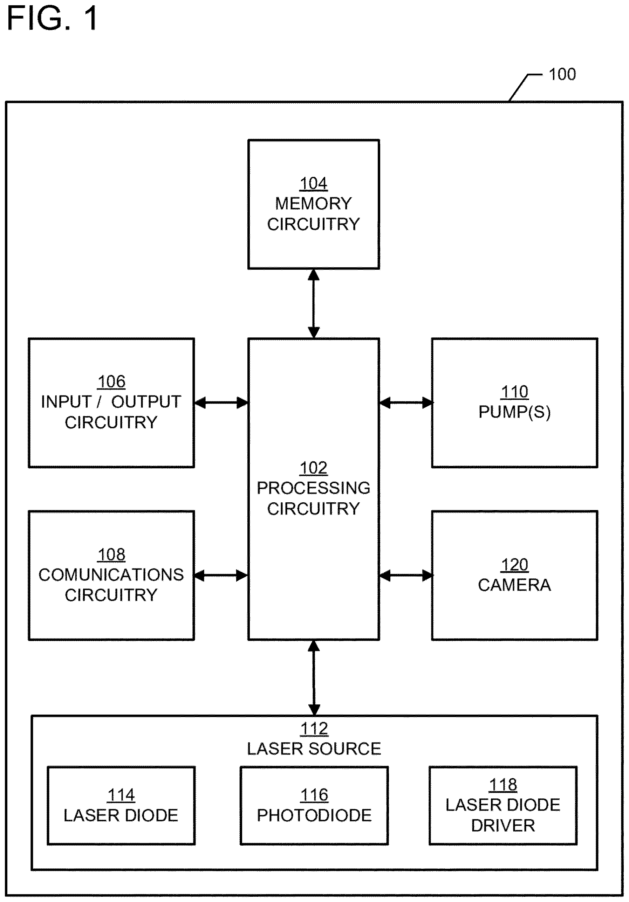

Referring now to FIG. 1, a block diagram of an example device in which example embodiments of the present disclosure may be implemented is provided. For example, the example device may be a peritoneal dialysis device. As depicted in FIG. 1, in some embodiments the example device 100 comprises a processor or processing circuitry 102, memory circuitry 104, input/output circuitry 106, communications circuitry 108, one or more pumps 110, a laser source 112, and a camera 120. In some embodiments, one or more portions of the example device 100 are configured to execute and perform the operations described herein.

Although components are described with respect to functional limitations, it should be understood that at least some of the particular implementations necessarily include the use of particular computing hardware. It should also be understood that in some embodiments certain of the components described herein include similar or common hardware. For example, in some embodiments two sets of circuitry both leverage use of the same processor(s), memory(ies), circuitry(ies), and/or the like to perform their associated functions such that duplicate hardware is not required for each set of circuitry.

Processing circuitry 102 may be embodied in a number of different ways. In various embodiments, the use of the terms "processor" or "processing circuitry" should be understood to include a single core processor, a multi-core processor, multiple processors internal to the example device 100, and/or one or more remote or "cloud" processor(s) external to the example device 100. In some example embodiments, processing circuitry 102 may include one or more processing devices configured to perform independently. Alternatively, or additionally, processing circuitry 102 may include one or more processor(s) configured in tandem via a bus to enable independent execution of operations, instructions, pipelining, and/or multithreading.

In an example embodiment, the processing circuitry 102 may be configured to execute instructions stored in the memory circuitry 104 or otherwise accessible to the processor. Alternatively, or additionally, the processing circuitry 102 may be configured to execute hard-coded functionality. As such, whether configured by hardware or software methods, or by a combination thereof, processing circuitry 102 may represent an entity (e.g., physically embodied in circuitry) capable of performing operations according to embodiments of the present disclosure while configured accordingly. Alternatively, or additionally, processing circuitry 102 may be embodied as an executor of software instructions, and the instructions may specifically configure the processing circuitry 102 to perform the various algorithms embodied in one or more operations described herein when such instructions are executed. In some embodiments, the processing circuitry 102 includes hardware, software, firmware, and/or a combination thereof that performs one or more operations described herein.

In some embodiments, the processing circuitry 102 (and/or co-processor or any other processing circuitry assisting or otherwise associated with the processor) is/are in communication with the memory circuitry 104 via a bus for passing information among components of the example device 100.

Memory or memory circuitry 104 may be non-transitory and may include, for example, one or more volatile and/or non-volatile memories. In some embodiments, the memory circuitry 104 includes or embodies an electronic storage device (e.g., a computer readable storage medium). In some embodiments, the memory circuitry 104 is configured to store information, data, content, applications, instructions, or the like, for enabling the example device 100 to carry out various operations and/or functions in accordance with example embodiments of the present disclosure.

Input/output circuitry 106 may be included in the example device 100. In some embodiments, input/output circuitry 106 may provide output to the user and/or receive input from a user. The input/output circuitry 106 may be in communication with the processing circuitry 102 to provide such functionality. The input/output circuitry 106 may comprise one or more user interface(s). In some embodiments, a user interface may include a display that comprises the interface(s) rendered as a web user interface, an application user interface, a user device, a backend system, or the like. In some embodiments, the input/output circuitry 106 also includes a keyboard, a mouse, a joystick, a touch screen, touch areas, soft keys a microphone, a speaker, or other input/output mechanisms. The processing circuitry 102 and/or input/output circuitry 106 may be configured to control one or more operations and/or functions of one or more user interface elements through computer program instructions (e.g., software and/or firmware) stored on a memory accessible to the processor (e.g., memory circuitry 104, and/or the like). In some embodiments, the input/output circuitry 106 includes or utilizes a user-facing application to provide input/output functionality to a computing device and/or other display associated with a user. In some embodiments, for example, the input/output circuitry 106 comprises indicator lights 110.

Communications circuitry 108 may be included in the example device 100. The communications circuitry 108 may include any means such as a device or circuitry embodied in either hardware or a combination of hardware and software that is configured to receive and/or transmit data from/to a network and/or any other device, circuitry, or module in communication with the example device 100. In some embodiments the communications circuitry 108 includes, for example, a network interface for enabling communications with a wired or wireless communications network. Additionally or alternatively, the communications circuitry 108 may include one or more network interface card(s), antenna(s), bus(es), switch(es), router(s), modem(s), and supporting hardware, firmware, and/or software, or any other device suitable for enabling communications via one or more communications network(s). In some embodiments, the communications circuitry 108 may include circuitry for interacting with an antenna(s) and/or other hardware or software to cause transmission of signals via the antenna(s) and/or to handle receipt of signals received via the antenna(s). In some embodiments, the communications circuitry 108 enables transmission to and/or receipt of data from a user device, one or more sensors, and/or other external computing device(s) in communication with the example device 100.

In some embodiments, the communications circuitry 108 transmits and/or receives (wired or wirelessly) information related to calibration of the laser source 112. In some embodiments, the communications circuitry 108 transmits and/or receives information from other components of the example device 100 using the Inter-Integrated Circuit (I2C) protocol.

One or more pumps 110 may be included in the example device 100. In some embodiments, such pumps pump the dialysis solution into and out of the patient's abdominal cavity.

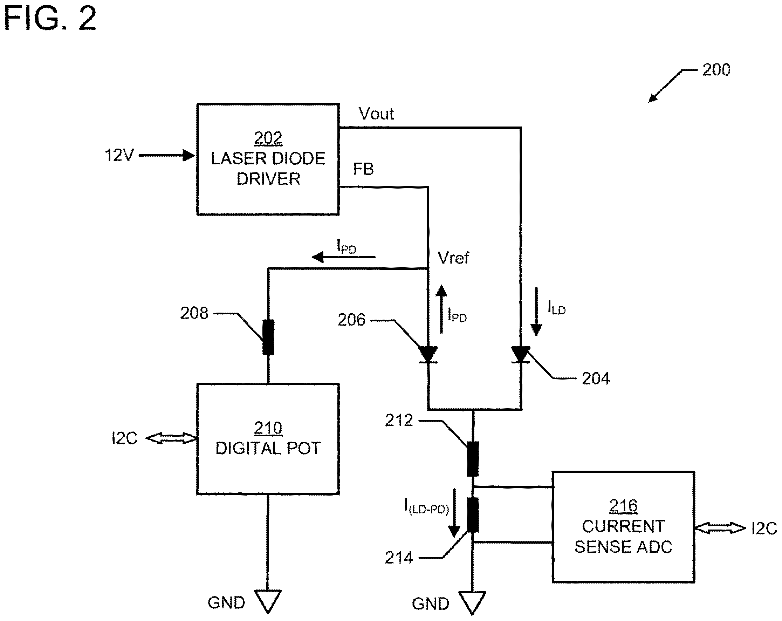

A laser source 112 may be included in the example device 100. In some embodiments, the laser source 112 comprises at least a laser diode 114, a photodiode 116, and a laser diode driver 118, all of which are described further below. In some embodiments, the laser diode 114 and the photodiode 116 are integrated into a single package. In some embodiments, the laser source also comprises additional components, as described further below in relation to FIG. 2.

A camera 120 may be included in the example device 100. In some embodiments, the camera 120 receives the laser light that has been emitted by the laser source 112 and has passed through a sample of the extracted dialysis solution to capture holographic images of bodily fluids for image analysis for identification of leukocytes.

In some embodiments, two or more of the sets of circuitry 102-108 are combinable. Alternatively, or additionally, one or more of the sets of circuitry 102-108 perform some or all of the operations and/or functionality described herein as being associated with another circuitry. In some embodiments, two or more of the sets of circuitry 102-108 are combined into a single module embodied in hardware, software, firmware, and/or a combination thereof.

While the description above provides an example device 100, it is noted that the scope of the present disclosure is not limited to the description above. In some examples, an example device 100 in accordance with the present disclosure may be in other forms. In some examples, an example device 100 may comprise one or more additional and/or alternative elements, and/or may be structured differently than that illustrated in FIG. 1.

Referring now to FIG. 2, a simplified circuit diagram of an example laser illumination device or laser source 200 is illustrated in accordance with example embodiments of the present disclosure. As depicted in FIG. 2, in some embodiments the example laser source 200 comprises a laser diode driver 202 powered by a 12 volt power supply, a laser diode 204 whose anode is connected to a voltage output (Vout) of the laser diode driver 202, and a photo diode 206 whose cathode is connected to the cathode of the laser diode 204 and whose anode is connected to a feedback input (FB) of the laser diode driver 202. As further depicted in FIG. 2, in some embodiments the example laser source 200 also comprises a fixed value resistor 208 and a variable resistor such as digital potentiometer 210 (which may be abbreviated as DPOT) to provide a variable resistance connected in series between the anode of the photodiode 206 and ground. As further depicted in FIG. 2, in some embodiments the example laser source 200 also comprises a first resistor 212 and a second resistor 214 connected in series between the cathodes of the laser diode 204 and the photo diode 206 and ground, and a current sense analog-to-digital converter (ADC) 216 connected across the second resistor 214 to measure the current flowing through the second resistor 214. In some embodiments, the current flowing through the second resistor 214 is equal to the laser diode current minus the photodiode current and may be used to determine the laser diode current (described further below) since the laser diode current cannot be directly measured or calculated. In some embodiments, the digital potentiometer 210 communicates with a processor (such as processing circuitry 102) via I2C protocol to receive a signal indicating the desired setting of the digital potentiometer 210. In some embodiments, the ADC 216 communicates with a processor (such as processing circuitry 102) via I2C protocol to send the measured current.

In some embodiments, the selectable resistance value is selected, in combination with the resistance value of the fixed resistor 208, to maintain a reference voltage (Vref) on the anode of the photodiode 206 to reverse bias the photodiode 206. In some embodiments, the reference voltage is 1.24 volts, although any suitable reference voltage may be used. In some embodiments, the fixed resistor 208 is a 6200 ohm resistor, although any suitable resistor value may be used. In some embodiments, the digital potentiometer 210 has a selectable resistance value of between 0 and 50,000 ohms, although any suitable range of resistance values may be used. In some embodiments, the resistance value of the digital potentiometer 210 is selectable in 128 increments (typically referred to as steps 0-127) via a 7-bit signal.

In operation, the laser diode driver 202 outputs a voltage (Vout) to the anode of the laser diode 204. The output voltage is selected to produce a current (I_{LD}) through the laser diode 204 to cause the laser diode 204 to emit the desired laser light. The photodiode 206 senses the laser light and produces a current (I_{PD}) in response. Because the photodiode 206 is reverse biased, the response of the photodiode 206 to the received illumination is linear. Based on the total resistance value of the fixed resistor 208 and the digital potentiometer 210, the desired reference voltage (Vref) is maintained on the feedback input of the laser diode driver 202 when the laser diode 204 is producing the desired optical power output. If the optical power output of the laser diode reduces due to a temperature increase, the photodiode current (I_{PD}) decreases and the reference voltage (Vref) decreases. The laser diode driver 202 detects the change and adjusts its output (Vout) to the laser diode 204 to maintain the desired optical power output.

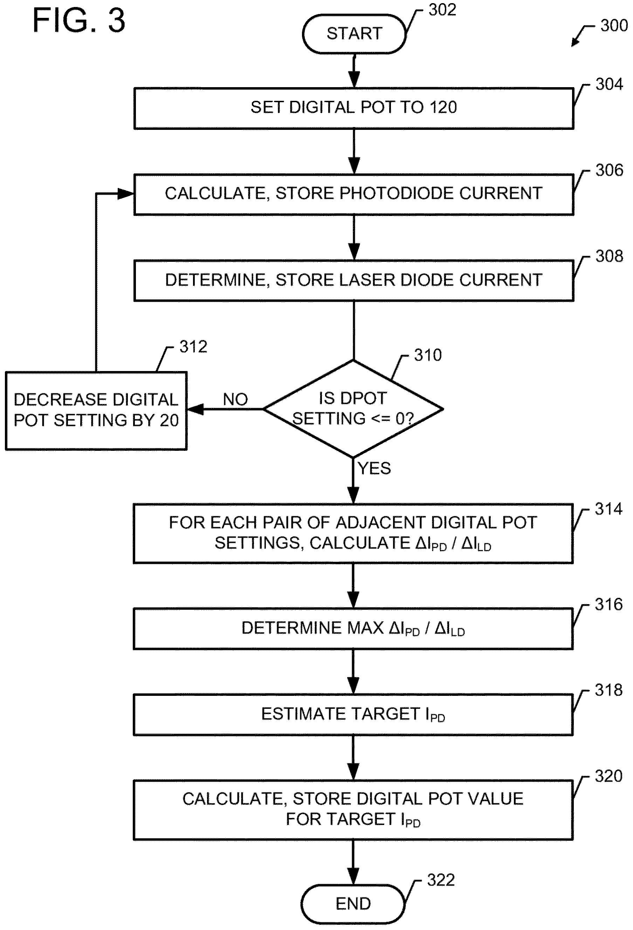

Reference will now be made to FIG. 3 which provides a flowchart illustrating example steps, processes, procedures, and/or operations in accordance with various embodiments of the present disclosure. Various methods described herein, including, for example, methods as shown in FIG. 3, may provide various technical benefits and improvements.

In some embodiments, the example method comprises a method for calibrating a laser illumination device. The example method for calibrating a laser illumination device may be performed once before operation of the device begins and/or repeatedly as needed during its operational life. Because of the linear relationship between the response of the photodiode and the received illumination due to the reverse biasing of the photodiode, the calibration method of embodiments of the invention is simpler and faster than conventional methods in which the photodiode is forward biased and the response of the photodiode is non-linear.

In some embodiments, the example method sets the variable resistor to a plurality of different resistance values, determines the laser diode current and the photodiode current for each different variable resistance value, calculates a ratio of the photodiode current difference to the laser diode current difference for each pair of adjacent variable resistance values, uses the maximum ratio to determine a target photodiode current, and uses the target photodiode current to determine the variable resistance value to be used during operation of the laser illumination device.

Referring now to FIG. 3, an example method 300 is illustrated. The example method begins at step/operation 302. At step/operation 304, a processor (such as, but not limited to, the processing circuitry 102 of the example device 100 described above in connection with FIG. 1) sets a first setting (corresponding to a first resistance value) of a potentiometer (such as, but not limited to, the digital potentiometer 210 of the example laser source 200 described above in connection with FIG. 2). In some embodiments, the digital potentiometer has a selectable resistance value of between 0 and 50,000 ohms, and the resistance value is selectable in 128 increments (typically referred to as steps 0-127) via a 7-bit signal from the processor. In the illustrated method of FIG. 3, the plurality of different resistance values correspond to steps 120, 100, 80, 60, 40, and 20 on the digital potentiometer, which in a digital potentiometer with a selectable resistance value of between 0 and 50,000 ohms would correspond respectively to approximately 46.9, 39.1, 31.3, 23.4, 15.6 and 7.8 kiloohms. As such, in the example method of FIG. 3, the first resistance value set in step/operation 304 is step 120 (which would correspond to 46.9 kiloohms).

At step/operation 306, a processor (such as, but not limited to, the processing circuitry 102 of the example device 100 described above in connection with FIG. 1) calculates the photodiode current and stores the calculated value. In the illustrated embodiment, the photodiode current is calculated using the formula: I_{PD} = Vref / (R_{FIXED} + R_{DPOT}), where I_{PD} is the photodiode current, Vref is the reference voltage, R_{FIXED} is the resistance value of the fixed resistor, and R_{DPOT} is the resistance value of the digital potentiometer that is set at this step/operation.

At step/operation 308, a processor (such as, but not limited to, the processing circuitry 102 of the example device 100 described above in connection with FIG. 1) determines the laser diode current and stores the determined value. In some embodiments, the laser diode current is determined by measuring the current flowing through the second resistor and adding the photodiode current calculated at step/operation 306 to the measured current flowing through the second resistor (which, as described above, is equal to the laser diode current minus the photodiode current).

At step/operation 310, a processor (such as, but not limited to, the processing circuitry 102 of the example device 100 described above in connection with FIG. 1) determines if the setting of the digital potentiometer is less than or equal to zero. If it is determined at step/operation 310 that the setting of the digital potentiometer is not less than or equal to zero, the example method 300 proceeds to step/operation 312.

At step/operation 312, a processor (such as, but not limited to, the processing circuitry 102 of the example device 100 described above in connection with FIG. 1) decreases the setting of the digital potentiometer to a second setting (corresponding to a second resistance value). In the illustrated embodiment, the second setting would be 100 (corresponding to a resistance value of about 39.1 kiloohms). The example method 300 then proceeds to step/operation 306. Steps/operations 306-310 are repeated until it is determined at step/operation 310 that the setting of the digital potentiometer is less than or equal to zero. In the illustrated embodiment, steps/operations 306-310 would be performed six times (for each of the digital potentiometer settings 120, 100, 80, 60, 40, and 20).

If it is determined at step/operation 310 that the setting of the digital potentiometer is less than or equal to zero, the example method 300 proceeds to step/operation 314. At step/operation 314, a processor (such as, but not limited to, the processing circuitry 102 of the example device 100 described above in connection with FIG. 1) calculates a ratio of the photodiode current difference to the laser diode current difference at each pair of adjacent variable resistance values. For example, the photodiode current at digital potentiometer setting 100 is subtracted from the photodiode current at digital potentiometer setting 120 (this may be designated as ΔI_{PD}), the laser diode current at digital potentiometer setting 100 is subtracted from the laser diode current at digital potentiometer setting 120 (this may be designated as ΔI_{LD}), and the ratio of ΔI_{PD} / ΔI_{LD} is calculated. In the illustrated example, this is repeated for digital potentiometer setting pairs 100 and 80, 80 and 60, 60 and 40, and 40 and 20.

At step/operation 316, a processor (such as, but not limited to, the processing circuitry 102 of the example device 100 described above in connection with FIG. 1) determines the maximum of the multiple ΔI_{PD} / ΔI_{LD} ratios calculated at step/operation 314. This maximum may be designated as (ΔI_{PD} / ΔI_{LD})ₘₐₓ.

At step/operation 318, a processor (such as, but not limited to, the processing circuitry 102 of the example device 100 described above in connection with FIG. 1) determines an estimated target photodiode current by multiplying the maximum of the multiple ΔI_{PD} / ΔI_{LD} ratios determined at step/operation 316 by a photodiode reference current value. Thus, in various embodiments the estimated target photodiode current is calculated using the formula: Target I_{PD} = (ΔI_{PD} / ΔI_{LD})ₘₐₓ × I_{PDref}, where I_{PDref} is the photodiode reference current value.

In some embodiments, the photodiode reference current value is a photodiode current that is within an operating range of the photodiode as determined by a manufacturer of the photodiode (or the combined laser diode / photodiode package). In some embodiments, the photodiode reference current value is a photodiode current that is specified as a typical photodiode current (also termed as typical monitor current) by a manufacturer of the photodiode (or the combined laser diode / photodiode package). In one example embodiment, the operating range of the photodiode is 0.1 milliamp (mA) to 2.0 mA and the selected reference current value is 0.7 mA. In other example embodiments, the selected reference current value is between 0.4 and 1.0 mA.

At step/operation 320, a processor (such as, but not limited to, the processing circuitry 102 of the example device 100 described above in connection with FIG. 1) calculates the digital potentiometer value corresponding to the target photodiode current and stores this value to be used during operation of the device. In some embodiments, the digital potentiometer value ("DPOT value") corresponding to the target photodiode current is calculated using the formula: DPOT value = ((Vref / (Target I_{PD} × 10⁻³)) - (fixed resistor value + DPOT wiper resistance)) x number of DPOT settings / maximum DPOT resistance. This DPOT value is stored and used to set the resistance of the DPOT for operation of the device.

The example method ends at step/operation 322. In some embodiments, the method 300 may be performed once before operation of the device begins and/or repeatedly as needed during its operational life.

Operations and processes described herein support combinations of means for performing the specified functions and combinations of operations for performing the specified functions. It will be understood that one or more operations, and combinations of operations, may be implemented by special purpose hardware-based computer systems which perform the specified functions, or combinations of special purpose hardware and computer instructions.

In some example embodiments, certain ones of the operations herein may be modified or further amplified as described below. Moreover, in some embodiments additional optional operations may also be included. It should be appreciated that each of the modifications, optional additions or amplifications described herein may be included with the operations herein either alone or in combination with any others among the features described herein.

The foregoing method and process descriptions are provided merely as illustrative examples and are not intended to require or imply that the steps of the various embodiments must be performed in the order presented. As will be appreciated by one of skill in the art the order of steps in the foregoing embodiments may be performed in any order. Words such as "thereafter," "then," "next," and similar words are not intended to limit the order of the steps; these words are simply used to guide the reader through the description of the methods. Further, any reference to claim elements in the singular, for example, using the articles "a," "an" or "the," is not to be construed as limiting the element to the singular and may, in some instances, be construed in the plural.

While various embodiments in accordance with the principles disclosed herein have been shown and described above, modifications thereof may be made by one skilled in the art without departing from the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above, but is defined by the claims which follow, that scope including all equivalents of the subject matter of the claims. Each and every claim is incorporated as further disclosure into the specification and the claims are embodiment(s) of the present disclosure. Furthermore, any advantages and features described above may relate to specific embodiments but shall not limit the application of such issued claims to processes and structures accomplishing any or all of the above advantages or having any or all of the above features.

In addition, the section headings used herein are provided for consistency with the suggestions under 37 C.F.R. § 1.77 or to otherwise provide organizational cues. These headings shall not limit or characterize the disclosure set out in any claims that may issue from this disclosure. For instance, a description of a technology in the "Background" is not to be construed as an admission that certain technology is prior art to any disclosure in this disclosure. Neither is the "Summary" to be considered as a limiting characterization of the disclosure set forth in issued claims. Furthermore, any reference in this disclosure to "disclosure" or "embodiment" in the singular should not be used to argue that there is only a single point of novelty in this disclosure. Multiple embodiments of the present disclosure may be set forth according to the limitations of the multiple claims issuing from this disclosure, and such claims accordingly define the disclosure, and their equivalents, which are protected thereby. In all instances, the scope of the claims shall be considered on their own merits in light of this disclosure but should not be constrained by the headings set forth herein.

Also, systems, subsystems, apparatuses, techniques, and methods described and illustrated in the various embodiments as discrete or separate may be combined or integrated with other systems, modules, techniques, or methods without departing from the scope of the present disclosure. Other devices or components shown or discussed as coupled to, or in communication with, each other may be indirectly coupled through some intermediate device or component, whether electrically, mechanically, or otherwise. Other examples of changes, substitutions, and alterations are ascertainable by one skilled in the art and could be made without departing from the scope disclosed herein.

Many modifications and other embodiments of the disclosure set forth herein will come to mind to one skilled in the art to which these embodiments pertain having the benefit of teachings presented in the foregoing descriptions and the associated figures. Although the figures only show certain components of the apparatuses and systems described herein, various other components may be used in conjunction with the components and structures disclosed herein. Therefore, it is to be understood that the disclosure is not to be limited to the specific embodiments disclosed and that modifications and other embodiments are intended to be included within the scope of the appended claims. For example, the various elements or components may be combined, rearranged, or integrated in another system or certain features may be omitted or not implemented. Moreover, the steps in any method described above may not necessarily occur in the order depicted in the accompanying drawings, and in some cases one or more of the steps depicted may occur substantially simultaneously, or additional steps may be involved. Although specific terms are employed herein, they are used in a generic and descriptive sense only and not for purposes of limitation.

## Claims

1. A laser illumination device comprising:
a laser diode having an anode and a cathode;
a photodiode having an anode and a cathode, the cathode of the photodiode connected to the cathode of the laser diode;
a laser diode driver having a voltage output connected to the anode of the laser diode and a feedback input connected to the anode of the photodiode; and
a variable resistor with a selectable resistance value connected between the anode of the photodiode and ground;
wherein the selectable resistance value is selected to maintain a reference voltage on the anode of the photodiode to reverse bias the photodiode.

2. The laser illumination device of claim 1, wherein the variable resistor with the selectable resistance value comprises a digital potentiometer.

3. The laser illumination device of claim 2, further comprising a microcontroller in communication with the digital potentiometer for selecting the selectable resistance value.

4. The laser illumination device of claim 1, further comprising:
first and second resistors connected in series between the cathodes of the laser diode and the photodiode and ground; and
a current sense analog-to-digital controller (ADC) connected in parallel across one of the first and second resistors for measuring current through the one of the first and second resistors.

5. The laser illumination device of claim 1, further comprising a fixed resistor connected in series with the variable resistor.

6. A method of biasing a photodiode of a laser illumination device, the method comprising:
connecting a cathode of a laser diode to a cathode of a photodiode;
connecting an output of a laser diode driver to an anode of the laser diode;
connecting an anode of the photodiode to a feedback input of the laser diode driver;
connecting a variable resistor with a selectable resistance value between the anode of the photodiode and ground; and
selecting a resistance value of the variable resistor to maintain a reference voltage on the anode of the photodiode to reverse bias the photodiode.

7. The method of claim 6, wherein the variable resistor with the selectable resistance value comprises a digital potentiometer.

8. The method of claim 7, further comprising communicating the selected resistance value from a microcontroller to the digital potentiometer.

9. The method of claim 6, further comprising:
connecting first and second resistors in series between the cathodes of the laser diode and the photodiode and ground;
connecting a current sense analog-to-digital controller (ADC) in parallel across one of the first and second resistors; and
measuring current through the one of the first and second resistors via the ADC.

10. The method of claim 6, further comprising connecting a fixed resistor in series with the variable resistor.

11. A method of calibrating a laser illumination device, the method comprising:
connecting a cathode of a laser diode to a cathode of a photodiode;
connecting an output of a laser diode driver to an anode of the laser diode;
connecting an anode of the photodiode to a feedback input of the laser diode driver;
connecting a variable resistor with a selectable resistance value between the anode of the photodiode and ground;
for each of a plurality of different selected resistance values of the variable resistor, determining a photodiode current and a laser diode current;
for each pair of adjacent values of the plurality of different selected resistance values of the variable resistor, calculating a ratio of (i) a difference between the photodiode current at a second selected resistance value and the photodiode current at a first selected resistance value and (ii) a difference between the laser diode current at the second selected resistance value and the laser diode current at the first selected resistance value;
determining a maximum one of the calculated ratios;
determining a target photodiode current by multiplying the maximum one of the calculated ratios by a photodiode reference current value within an operating range of the photodiode; and
calculating an operating resistance value of the variable resistor using the target photodiode current.

12. The method of claim 11, wherein the variable resistor with the selectable resistance value comprises a digital potentiometer.

13. The method of claim 12, further comprising communicating each of the plurality of different selected resistance values and the calculated operating resistance value from a microcontroller to the digital potentiometer.

14. The method of claim 11, further comprising:
connecting first and second resistors in series between the cathodes of the laser diode and the photodiode and ground;
connecting a current sense analog-to-digital controller (ADC) in parallel across one of the first and second resistors;
measuring current through the one of the first and second resistors via the ADC; and
adding the measured current through the one of the first and second resistors to the determined photodiode current to determine the laser diode current.

15. The method of claim 11, further comprising connecting a fixed resistor in series with the variable resistor;
wherein the photodiode current is determined by dividing a reference voltage on the anode of the photodiode by a sum of the selected resistance value of the variable resistor and a resistance value of the fixed resistor.
